# EUROPEAN PATENT APPLICATION

(11) **EP 1 986 297 A2**
(43) Date of publication of application: **29.10.2008**
(21) Application number: 08155212.7
(22) Date of filing: 25.04.2008
(51) Int. Cl.: H01T 4/08

(54) **Spark gaps for ESD protection**

(30) Priority: 25.04.2007 US 926187 P
(71) Applicant: MediaTek Inc., 1st Science-Based Industrial Park Hsin-Chu 300 (TW)
(72) Inventor: Viborg, Karsten, 9230, Svenstrup (DK); Harrebek, Johannes, 9000, Aalborg (DK)
(74) Representative: Peterreins, Frank

(57) **Abstract**

An electronic circuit includes a first signal line that extends along a first direction, a spark gap device that has a first conductive trace and a second conductive trace, the first conductive trace being connected to the first signal line. The first and second conductive traces are spaced apart to define a spark gap, the first and second conductive traces being aligned along the first direction to direct an electrostatic discharge along the first direction from the first signal line through the spark gap to a ground reference electrically coupled to the second conductive trace. A second signal line is connected to the first conductive trace or to the first signal line in a vicinity of the first conductive trace, the second signal line extending along a second direction at an angle relative to the first direction.

## Description

### RELATED APPLICATIONS

This application claims priority to U.S. Patent Application Serial No. 60/926,187 filed on April 25, 2007, the contents of which are incorporated herein by reference.

### BACKGROUND

This description relates to spark gaps for electrostatic discharge (ESD) protection.

Electronic circuits in wireless handsets can be sensitive to electrostatic discharges (ESDs). In some examples, ESD protection is implemented using a single or an array of transient voltage suppression (TVS) diodes or multilayer varistor (MLV) filters. The TVS diode shunts excess current when a voltage above an avalanche breakdown voltage is applied. The TVS diode acts as a clamping device to suppress voltages above its breakdown voltage. The multilayer varistor can have a variable resistance. When a low voltage is applied to the MLV, the MLV has a high impedance. When a high voltage above a threshold is applied to the MLV, the MVL has a low impedance, allows the current to flow through to ground, and clamps the applied voltage to a specified value. After the spike voltage and current passes, the MLV returns to its high impedance state.

### SUMMARY

In general, in one aspect, a first conductive line has a first end and a second end, the second end being electrically coupled to a ground reference of an electronic circuit; a second conductive line has a first end and a second end, the first end of the second conductive line being spaced apart from the first end of the first conductive line to define a spark gap between the first ends of the first and second conductive lines, the second end of the second conductive line being electrically coupled to a node to receive a signal. A third conductive line is connected to the second conductive line in a vicinity of the first end of the second conductive line, the third conductive line being electrically coupled to an electronic component of the electronic circuit, in which the third conductive line has a segment connected to the second conductive line and the segment is at an angle with respect to the second conductive line.

Implementations may include one or more of the following features. The first and second conductive lines can provide a straight discharge path through a segment of the second conductive line and the spark gap to the first end of the first conductive line. The first and second conductive lines can provide a discharge path through a segment of the second conductive line and the spark gap to the first end of the first conductive line, the discharge path bending less than 30 degrees. The segment of the third conductive line can be at an angle in a range of 75 to 105 degrees (e.g., perpendicular) relative to the second conductive line. The third conductive line can have a bend (e.g., having an angle in a range between 75 to 105 degrees, e.g., 90 degrees) to reduce a likelihood that an electrostatic discharge will pass through the third conductive line to the electronic component. The third conductive line can have a segment that extends from the second conductive line to the bend, the segment extending along a direction at an angle (e.g., in a range between 75 to 105 degrees, e.g., 90 degrees) relative to a discharge path from the second conductive line through the spark gap to the first conductive line.

The first and second conductive lines can be disposed on a surface of a circuit board or an inner layer of a multi-layer circuit board. The first ends of the first and second conductive lines can each include a tapered portion. The first ends of the first and second conductive lines can be tapered along a first direction, and the second conductive line can extend along the first direction. The first conductive line can include a first solder pad located in a vicinity of the first end of the first conductive line, the second conductive line can include a second solder pad located in a vicinity of the first end of the second conductive line, and the first and second solder pads can be spaced apart at a distance to connect to connectors of an electrostatic discharge (ESD) protection device. The ESD protection device can include a multilayer varistor or a transient voltage suppressor. The ESD protection device can be stacked above the spark gap. The node can be configured to receive the signal from a source external to the electronic circuit.

In general, in another aspect, a first signal line extends along a first direction; a spark gap device has a first conductive trace and a second conductive trace, the first conductive trace being connected to the first signal line, the first and second conductive traces being spaced apart to define a spark gap, the first and second conductive traces being aligned along the first direction to direct an electrostatic discharge along the first direction from the first signal line through the spark gap to a ground reference electrically coupled to the second conductive trace; and a second signal line is connected to the first conductive trace or to the first signal line in a vicinity of the first conductive trace, the second signal line extending along a second direction at an angle relative to the first direction.

Implementations may include one or more of the following features. The first direction can be at an angle in a range between 75 to 105 degrees relative to the second direction. The first and second conductive traces can be disposed on a surface of a substrate, and the apparatus can include an electrostatic discharge protection device stacked above the spark gap relative to the surface, the electrostatic discharge protection device having connectors that are coupled to portions of the first and second conductive traces, respectively. The electrostatic discharge protection device can include a multilayer varistor or a transient voltage suppressor. The second signal line can be connected to a wider portion of the first conductive trace. The second signal line can be connected to the first signal line at a first intersection point in a vicinity of the first conductive trace. The first and second conductive traces can each include a tapered conductive trace having a wider portion and a narrower portion, and the narrower portion of the first conductive trace is spaced apart from the narrower portion of the second conductive trace to define the spark gap.

In general, in another aspect, a first conductive trace is electrically coupled to a ground reference of an electronic circuit; and a second conductive trace is spaced apart from the first conductive trace to define a spark gap. A first conductive line has a first end and a second end, the first end being connected to the second conductive trace, the second end being electrically coupled to a node to receive a signal; and a second conductive line has a first end and a second end, the first end of the second conductive line being connected to the second conductive trace, the second end of the second conductive line being connected to an electronic component of the electronic circuit. The first conductive line has a first segment that is connected to the second conductive trace, the second conductive line has a second segment that is connected to the second conductive trace, and the first segment is at an angle relative to the second segment.

Implementations may include one or more of the following features. The first conductive trace can have a wider portion and a narrower portion, and the wider portion can be electrically coupled to the ground reference. The second conductive trace can have a wider portion and a narrower portion, and the narrower portion of the second conductive trace is spaced apart from the narrower portion of the first conductive trace to define the spark gap. The first segment is at an angle in a range between 75 to 105 degrees relative to the second segment. The first segment of the first conductive line can be parallel to, or at an angle within a range between -15 to 15 degrees relative to, a discharge path from the narrower portion of the second conductive trace to the narrower portion of the first conductive trace. The second segment of the second conductive line can be perpendicular to, or at an angle within a range between 75 to 105 degrees relative to, a discharge path from the narrower portion of the second conductive trace to the narrower portion of the first conductive trace. The first and second conductive lines, and the first and second conductive traces, can be disposed on a surface of a circuit board or an inner layer of a multi-layer circuit board.

The first conductive line can include a first solder pad located in a vicinity of the first end of the first conductive line, the second conductive line can include a second solder pad located in a vicinity of the first end of the second conductive line, and the first and second solder pads can be spaced apart at a distance to connect to connectors of an ESD protection device. The ESD protection device can include a multilayer varistor or a transient voltage suppressor. The ESD protection device can be stacked above the spark gap. The second conductive line can have a third segment that is connected to the second segment and at an angle relative to the second segment.

In general, in another aspect, a conductive line has a first segment and a second segment that is at an angle relative to the first segment, the first segment receives a signal from a pad, and the second segment connects to an electronic component of an electronic circuit. A first conductive trace is coupled to the conductive line at an intersection of the first and second segments, and a second conductive trace is spaced apart from the first conductive trace to define a spark gap, the second conductive trace being electrically coupled to a ground reference of the electronic circuit.

Implementations may include one or more of the following features. The first segment of the conductive line can be parallel to, or at an angle within a range of -15 to 15 degrees relative to, an electrostatic discharge path through the spark gap, and the second segment of the conductive line can be perpendicular to, or at an angle within a range of 75 to 105 degrees relative to, the electrostatic discharge path through the spark gap. The second segment of the conductive line can include a first sub-segment and a second sub-segment that is at an angle relative to the second sub-segment, and the first sub-segment is connected to the first conductive trace. The second sub-segment can be at an angle in a range of 75 to 105 degrees (e.g., 90 degrees) relative to the first sub-segment. The first conductive trace can include a first solder pad, the second conductive trace can include a second solder pad, and the first and second solder pads can be spaced apart at a distance to connect to connectors of an electrostatic discharge (ESD) protection device. The ESD protection device can be stacked above the spark gap.

In general, in another aspect, a first conductive trace is coupled to a signal line; a second conductive trace is spaced apart from the first conductive trace to define a spark gap, the second conductive trace being electrically coupled to a ground reference of an electronic circuit; and an ESD protection device has a first connector and a second connector, the first connector being connected to the first conductive trace, the second connector being connected to the second conductive trace.

Implementations may include the following feature. The ESD protection device can include a multilayer varistor or a transient voltage suppressor.

In general, in another aspect, a wireless device includes a conductive line that provides an electrically conductive path from a connector pin or pad to an electronic component of an electronic circuit, the connector pin or pad receiving a signal from a source that is external to the wireless device, the conductive line having a first bend and a second bend. A first conductive trace is coupled to the conductive line at the first bend; and a second conductive trace is spaced apart from the first conductive trace to define a spark gap, the second conductive trace being electrically coupled to a ground reference of the electronic circuit.

Implementations may include the following feature. Each of the first and second bends can form an angle in a range between 75 to 105 degrees (e.g., 90 degrees).

In general, in another aspect, an electrostatic discharge (ESD) pulse is discharged through a first conductive line, a first conductive trace connected to the first conductive line, a spark gap, and a second conductive trace to a ground reference of an electronic circuit, in which the first conductive trace and the second conductive trace are spaced apart to define the spark gap, and the second conductive trace is coupled to the ground reference. A signal is transmitted on the first conductive line and a second conductive line to or from an electronic component that is electrically coupled to the second conductive line, the second conductive line having a segment connected to the first conductive line or a portion of the first conductive trace, in which the segment is at an angle relative to the first conductive line.

Implementations may include one or more of the following features. A bend can be provided in the third conductive line to reduce a likelihood that the ESD pulse will pass through the third conductive line to the electronic component. The bend in the third conductive line can have an angle in a range between 75 to 105 degrees (e.g., 90 degrees). Passing a signal through the first conductive line can include passing a signal received from a source external to the electronic circuit. An ESD pulse can be discharged through an ESD protection device that has a first connector and a second connector, the first connector being coupled to the first conductive line, the second connector being coupled to the second conductive line. The first conductive line, the first conductive trace, the second conductive trace and the ground reference can be disposed on an outer or inner surface of a circuit board.

In general, in another aspect, a straight discharge path is provided for an electrostatic discharge (ESD) pulse to propagate from a first node through a first conductive trace and a spark gap to a second conductive trace electrically coupled to a ground reference of an electronic circuit. An electrically conductive path is provided for a signal to transmit between the node and an electronic component of the electronic circuit without passing the spark gap, in which the electrically conductive signal path includes at least one bend, and at least a portion of the electrically conductive signal path overlaps the straight discharge path.

Implementations may include one or more of the following features. The straight discharge path can overlap the electrically conductive path at the first signal line. The bend can be at a location where the electrically conductive path and the straight discharge path diverge. Another bend can be provided at a location of the electrically conductive path after the electrically conductive path diverge from the straight discharge path. An ESD protection device can be stacked above the spark gap to provide a second discharge path for the ESD pulse. Providing an electrically conductive path can include providing an electrically conductive path through conductive elements on an outer or inner surface of a circuit board.

These and other aspects and features, and combinations of them, may be expressed as methods, apparatus, systems, means for performing functions, and in other ways.

Advantages of the aspects and features include one or more of the following. ESD protection can be enhanced with little increase in cost. ESD requirements can be satisfied during wireless handset certifications. Adding off-chip printed circuit board ESD protection can prevent interruption to wireless device operation and prevent permanent damage to the wireless device. Manufacturers can have the option of using spark gap devices alone, or using spark gap devices in combination with TVS or MLV devices without modifying the printed circuit board. The combined spark gap device and TVS or MLV device can occupy a small area on the circuit board.

The details of one or more embodiments of the invention are set forth in the accompanying drawings and the description below. Other features, objects, and advantages of the invention will be apparent from the description and drawings, and from the claims.

### DESCRIPTION OF DRAWINGS

FIGS. 1 and 2 show schematic diagrams of example spark gap devices and signal lines.

FIG. 3 is a schematic layout diagram of an example spark gap device.

FIG. 4 is a circuit diagram of a portion of an example electronic circuit.

FIG. 5 is a schematic layout diagram of a portion of the electronic circuit of FIG. 4.

FIG. 6 is a circuit diagram of a portion of an example electronic circuit.

FIG. 7 is a schematic layout diagram of a portion of the electronic circuit of FIG. 6.

FIG. 8 is a cross-sectional diagram of an example combined ESD protection device.

FIG. 9 is a diagram of an example process for using an electronic device having a spark gap device.

FIG. 10 is a diagram of an example process for providing ESD protection to an electronic device.

FIGS. 11 and 12 show schematic diagrams of example spark gap devices and signal lines.

Like reference symbols in the various drawings indicate like elements.

### DETAILED DESCRIPTION

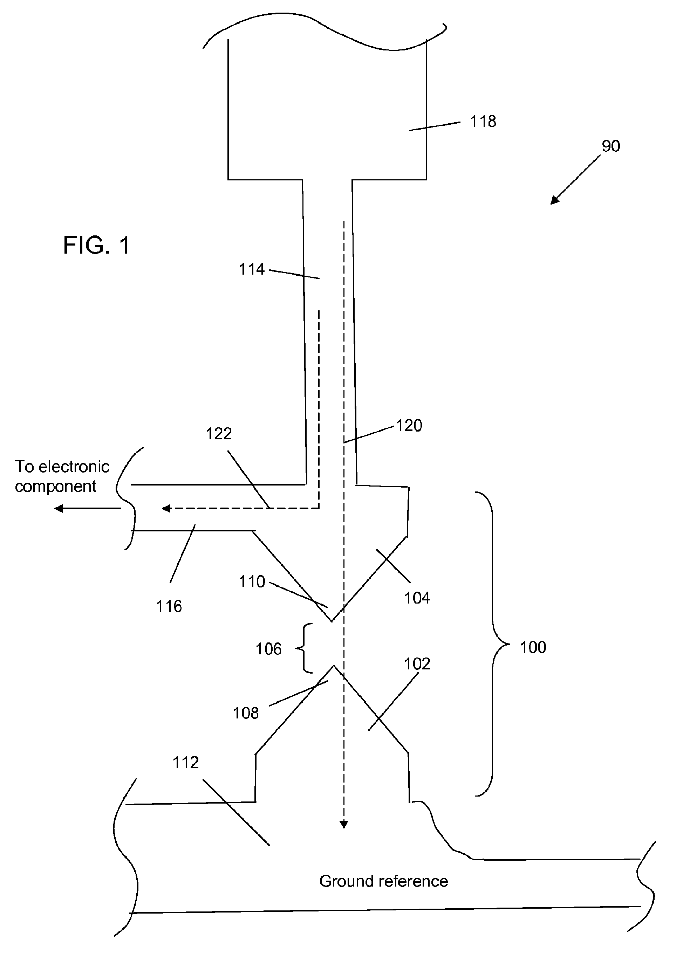

Referring to FIG. 1, an example electronic circuit 90 includes a spark gap device 100 having a first conductive trace 102 and a second conductive trace 104 that are spaced apart by a distance to define a spark gap 106. In some implementations, the conductive traces 102 and 104 are tapered to form pointed tips 108 and 110, respectively, facing each other that facilitate discharge of ESD pulses across the spark gap 106. The first conductive trace 102 is electrically coupled to a ground reference 112 having a ground reference voltage. The second conductive trace 104 is connected to a first signal line 114 that is electrically coupled to a node 118 that has a likelihood of receiving an electrostatic discharge. The node 118 can be, e.g., an input/output interface 118 that may come into contact with an external device or a user. The electronic circuit 90 can be used in, for example, wireless phones or other portable devices.

The spark gap device 100 has a breakdown voltage that varies depending on the geometry of the first and second conductive traces 102 and 104, and the spacing between the first and second conductive traces 102 and 104. When an ESD pulse having a voltage (relative to the ground reference voltage) that exceeds the breakdown voltage propagates to the conductive trace 104, an arc is generated across the spark gap 106, causing the ESD pulse to be discharged through the spark gap 106 and the conductive trace 102 to the ground reference 112.

A feature of the electronic circuit 90 is that the first signal line 114, the second conductive trace 104, and the first conductive trace 102 are aligned along a straight line, providing a straight discharge path 120 for an ESD pulse to travel from the first signal line 114 to the ground reference 112. A second signal line 116, connected to the conductive trace 104, extends along a direction that is perpendicular to the first signal line 114. The second signal line 116 may be electrically coupled to an electronic component that processes signals transmitted on the second signal line 116.

The spark gap device 100 has a high impedance for normal signals that the electronic circuit 90 is designed to process, so normal signals can propagate on the signal lines 114 and 116 without being affected by the spark gap device 100. When an ESD pulse is received at the node 118, the ESD pulse is more likely to propagate on the straight discharge path 120 than to travel a path 122 having a 90 degree bend from the first signal line 114 to the second signal line 122. This protects any electronic component connected to the second signal line 122 from damage by the high voltage ESD pulse.

In the example shown in FIG. 1, each of the conductive traces 102 and 104 has a tapered portion in the shape of a triangle. Other shapes and sizes can also be used for the conductive traces 102 and 104.

In some implementations, the first conductive trace 102, the second conductive trace 104, the first signal line 114, the second signal line 116, the ground reference 112, and the node 118 are fabricated on a surface of a substrate, such as a circuit board. They can also be fabricated in an inner layer of a multi-layer circuit board. The spark gap device 100 can be etched from the same metal layer used for the signal lines (e.g., 114 and 116), so little additional cost is needed to fabricate the spark gap device 100. Patterning the conductive traces 102 and 104 of the spark gap device 100 is similar to patterning the signal lines 114 and 116, so no additional processing step is required for fabricating the spark gap device 100.

The spark gap device 100 can be used at any part of the electronic circuit 90 where there is a possibility of an electrostatic discharge, or where sensitive components are located. For example, the spark gap device 100 can be used to provide ESD protection for keypad switches, battery contacts, charger contacts, SIM contacts, input/output connectors, or audio/video jacks, etc. The spark gap device 100 can also be connected to a metal housing that encloses the electronic circuit 90.

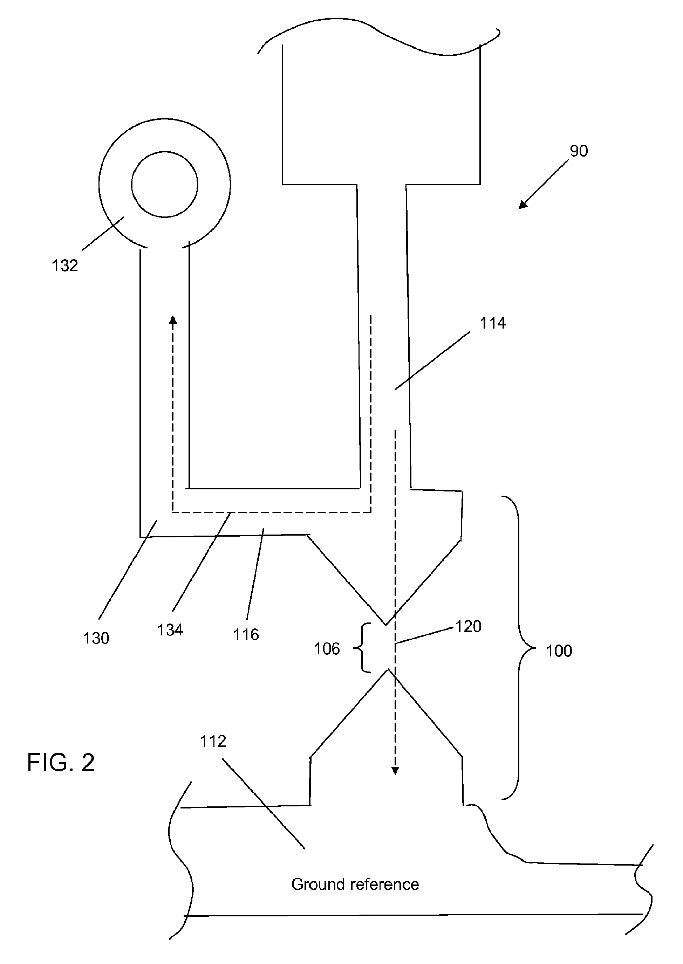

Referring to FIG. 2, in some implementations, the second signal line 116 has a bend 130, resulting in a signal path 134 having at least two bends from the first signal line 114 to an electronic component electrically coupled to the second signal line 116. Adding the bend 130 further reduces the likelihood that an electrostatic discharge will travel on the second signal line 116 to the electronic component, and increases the likelihood that the electrostatic discharge will discharge through the straight discharge path 120 to the ground reference 112.

In the example of FIG. 2, the circuit board is a multilayer circuit board, and one end of the second signal line 116 is connected to a via pad 132 that connects through a via to another signal line in another layer of the circuit board, the other signal line being electrically coupled to an electronic component.

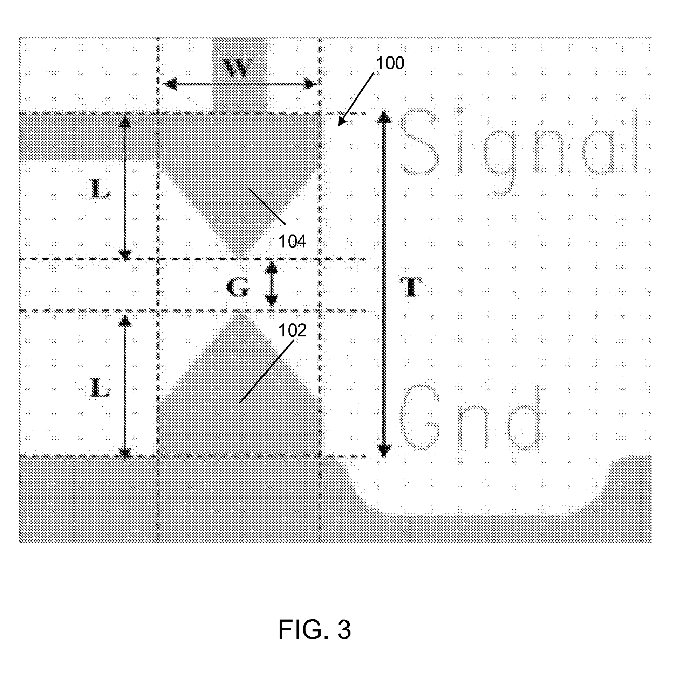

Referring to FIG. 3, in some implementations, the spark gap has a distance G equal to 4 mils (1 mil = 1/1000 inch), each of the conductive traces 102 and 104 has a width W equal to 12 mils and a length L equal 12 mils, and the spark gap device 100 has a total length T equal to 28 mils. This design can provide ESD protection for about 8 to 15 KV. The dimensions shown here are used as examples only. The spark gap device 100 can have other dimensions and shapes. For example, the spark gap G can be made smaller.

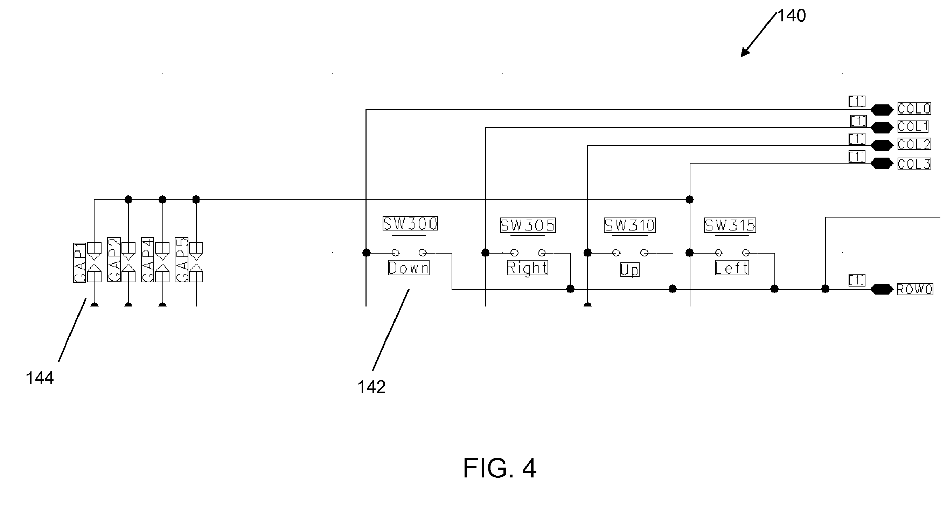

FIG. 4 is a circuit diagram of a portion of an example electronic circuit 140 that includes keypad switches 142 and spark gap devices 144.

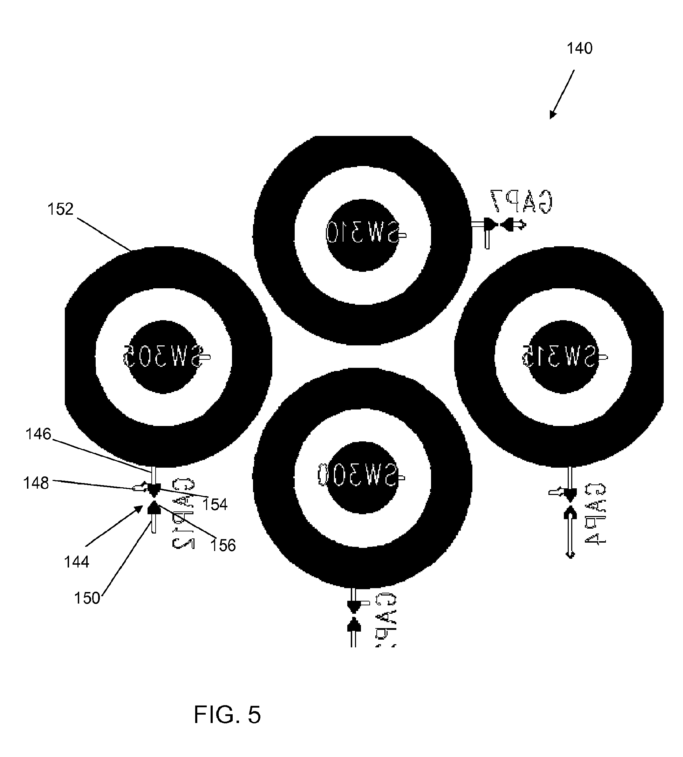

FIG. 5 is a layout diagram of a portion of the electronic circuit 140. Ring pads 152 are provided for the keypad switches 142, and conductive traces 154 and 156 are provided to form the spark gap devices 144. The ring pad 152 is connected to the conductive trace 154 through a signal line 146. The conductive trace 156 is electrically coupled to a ground reference. A signal line 148 is connected to the conductive trace 154 and an electronic component to process signals transmitted on the signal line 148. The signal line 148 extends along a direction that is perpendicular to the signal line 146. The signal line 146, the conductive trace 154, and the conductive trace 156 are aligned along a straight line. As described above, such configuration makes it more likely that an electrostatic discharge received at the ring pad 152 will discharge through a straight discharge path to the ground reference than pass to the electronic component through the signal line 148.

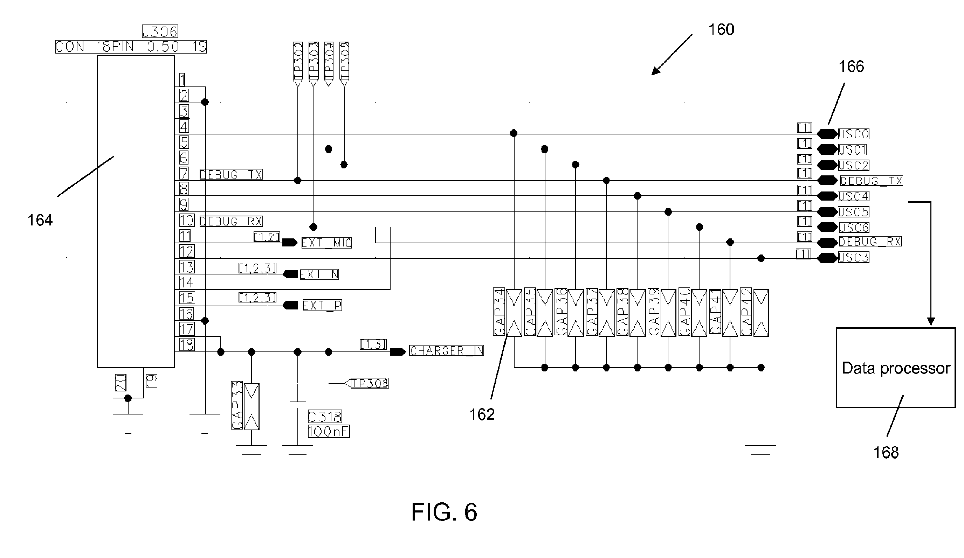

FIG. 6 is a circuit diagram of an example electronic circuit 160 that includes a connector 164 that can be accessed by a user (e.g., to connect to an external signal cable) and an interface 166 that connects to a signal processor 168 (or a data processor) for processing signals received from the connector 164. The circuit 160 includes combined ESD protection devices 162 to protect the signal processor 168 from electrostatic discharges received at the connector 164. Each combined ESD protection device 162 includes a combination of a spark gap device and another ESD protection device, such as a transient voltage suppression (TVS) diode or a multilayer varistor (MLV) filter (which sometimes are simply referred to as transient voltage suppressor or multilayer varistor).

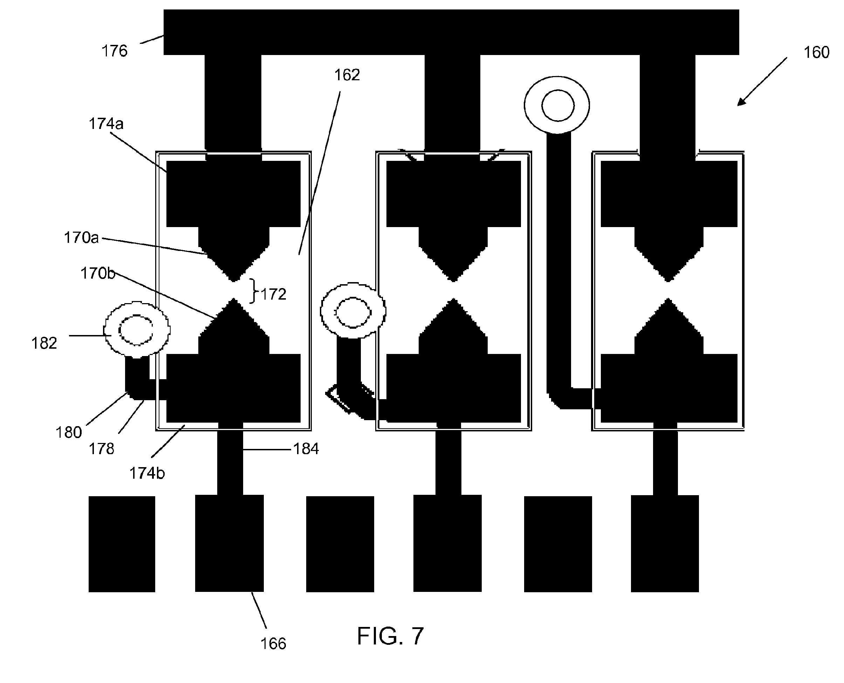

FIG. 7 is a layout diagram of a portion of the electronic circuit 160. The layout for the combined ESD protection device 162 includes conductive traces 170a and 170b that are spaced apart to define a spark gap 172. Solder pads 174a and 174b are connected to the conductive traces 170a and 170b, respectively. The solder pads 174a and 174b can be used to connect to connector pins of a TVS diode or an MLV filter. In this configuration, the spark gap device and the TVS diode or MLV filter are connected in parallel. Using a TVS diode or MLV filter in parallel with a spark gap can provide a higher level of ESD protection, e.g., by protecting electronic components against electrostatic discharges having higher voltage or power levels.

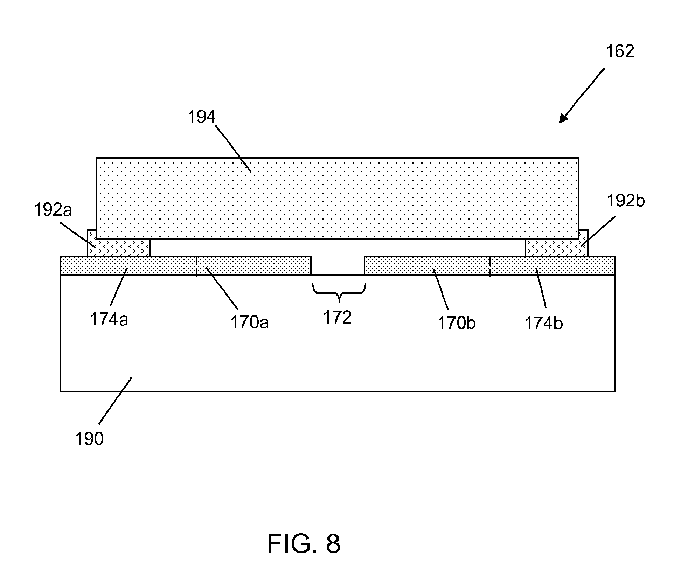

FIG. 8 is a cross-sectional diagram of an example combined ESD protection device 162 on a printed circuit board 190. The combined ESD protection device 162 includes conductive traces 170a and 170b that are spaced apart to define a spark gap 172. Solder pads 174a and 174b are provided to connect to connector pins 192a and 192b, respectively, of a TVS diode or an MLV filter 194.

Stacking a TVS diode or MLV filter above the spark gap 172 can reduce the area occupied by the ESD protection devices, as compared to placing the spark gap device and the TVS diode or MLV filter side-by-side. This is advantageous in wireless devices that have small circuit boards.

The layout design shown in FIG. 7 has the advantage of providing flexibility for a manufacturer of the electronic circuit 160 to decide whether to include a TVS diode or MLV filter after the circuit board has been designed or fabricated. For example, the same circuit board can be used with electronic components having different grades that can withstand different levels of electrostatic discharge. If an interface is electrically coupled to an electronic component that can withstand a higher electrostatic discharge, then a spark gap may provide sufficient ESD protection and it may not be necessary to stack a TVS or MLV device above the spark gap. On the other hand, if the interface is electrically coupled to an electronic component that can withstand a lower electrostatic discharge, then it may be useful to stack a TVS or MLV device above the spark gap to increase ESD protection. The TVS or MLV devices can be selectively added to a portion of the spark gap devices.

In some examples, a manufacturer may produce different models of electronic devices (e.g., wireless phones) using the same circuit board but executing different software applications and having different outer housing designs. A higher priced model of the wireless device may have software applications with greater functionalities. The manufacturer may decide to provide TVS or MLV devices in parallel to the spark gaps to enhance ESD protection. A lower cost model of the wireless device may have less software functionalities, and the manufacturer may decide to use the spark gaps for ESD protection without using the TVS or MLV devices.

In the example of FIG. 7, the conductive trace 170a is electrically coupled to a ground reference 176, and the conductive trace 170b is electrically coupled to a signal line 184, which in turn is connected to the interface node 166. The signal line 174, the conductive trace 170b, and the conductive trace 170a provide a straight discharge path for an electrostatic discharge received at the interface node 166.

A signal line 178 has one end that is connected to the solder pad 174b, and another end that is connected to a via pad 182 (which is electrically coupled to another signal line of another layer of the circuit board, the other signal line being connected to an electronic component). The signal line 178 has a first portion that is connected to the solder pad 174b, in which the first portion extends along a direction that is perpendicular to the signal line 174. This makes it less likely that an electrostatic discharge will pass through the signal line 178 to electronic components electrically coupled to the signal line 178. The signal line 178 has a bend 180 that turns 90 degrees, further decreasing the likelihood that an electrostatic discharge will pass through the signal line 178 to the electronic components, and increasing the likelihood that the electrostatic discharge will discharge through the straight discharge path to the ground reference 176.

In some implementations, a printed circuit board having spark gap devices 100 can be fabricated using the following process. A conductive layer (e.g., a copper sheet) is laminated on a non-conductive substrate (e.g., made of fiberglass, resin, or a composite material). The conductive layer is patterned using, e.g., a silk screen printing process to print patterns of signal lines and the conductive traces of the spark gap devices 100 on the substrate. Unwanted portions of the conductive layer is etched away. A protective coating is applied over the substrate and the remaining portions of the conductive layer. Vias or holes are formed by drilling through the substrate or by laser evaporation.

The circuit board is covered with a non-conductive protective coating (e.g., a solder resist mask) to prevent short circuits and to provide protection from the environment. At locations where electronic components will be mounted or soldered, e.g., portions of signal lines or connection pads, the protective coating is removed, and the exposed conductive layer is treated with a conductive protective coating, such as an electroless nickel immersion gold coating (ENIG) to prevent oxidization.

In some implementations where options for using combined ESD protection devices are provided, the non-conductive protective coating at solder pads of the conductive traces of the spark gap devices are removed, and the exposed solder pads are treated with the ENIG protective coating. In some examples, the non-conductive protective coating above the spark gap (e.g., 106) is removed. The steps described above are for example only, some steps may be removed, or additional steps may be included in the fabrication process.

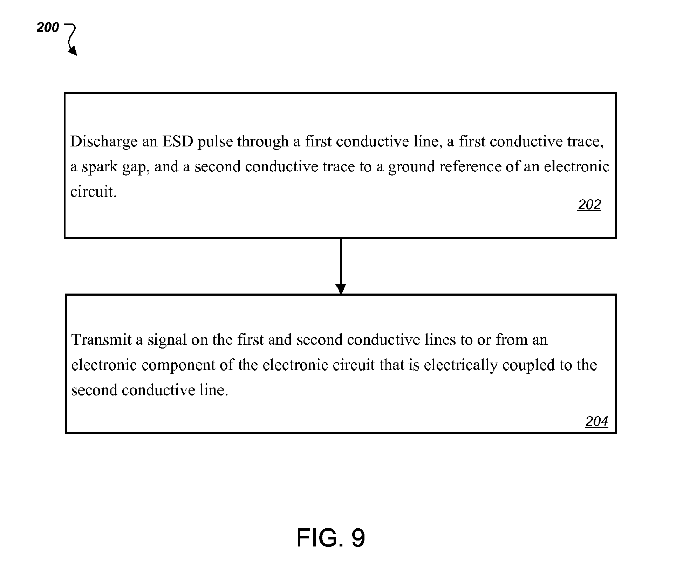

FIG. 9 is a diagram of an example process 200 for using an electronic device having a spark gap device. An ESD pulse is discharged through a first conductive line, a first conductive trace, a spark gap, and a second conductive trace to a ground reference of an electronic circuit (202). The first conductive trace and the second conductive trace are spaced apart to define the spark gap, and the second conductive trace is coupled to the ground reference. For example, the first conductive line, the first conductive trace, the spark gap, and the second conductive trace can provide a straight discharge path (e.g., 120 of FIG. 1) for the ESD pulse to pass to the ground reference. The first and second conductive traces can each have a tapered shape, such as a triangular shape. The first conductive line can be the conductive line 114, the second conductive line can be the conductive line 116, the first conductive trace can be the conductive trace 104, the second conductive trace can be the conductive trace 102, and the ground reference can be the ground reference 112.

A signal is transmitted on the first conductive line and a second conductive line to or from an electronic component that is electrically coupled to the second conductive line (204). The second conductive line has a segment connected to the first conductive line or a portion of the first conductive trace, in which the segment is at an angle relative to the first conductive line. For example, the angle can be 90 degrees. The first and second conductive lines can provide a conduction path (e.g., 122 of FIG. 1) that has a bend to reduce a likelihood that the ESD pulse will propagate on the second signal line to the electronic component. The second conductive line can have one or more bends to further reduce the likelihood that the ESD pulse will propagate on the second signal line to the electronic component.

For example, the second signal line can be the signal line 116 in FIG. 1. The signal can be a signal received from a source external to the electronic circuit. The ESD pulse can be discharged through an ESD protection device, such as a TVS or MLV that has a first connector and a second connector coupled to the first and second conductive traces, respectively. The TVS or MLV can be stacked above the spark gap.

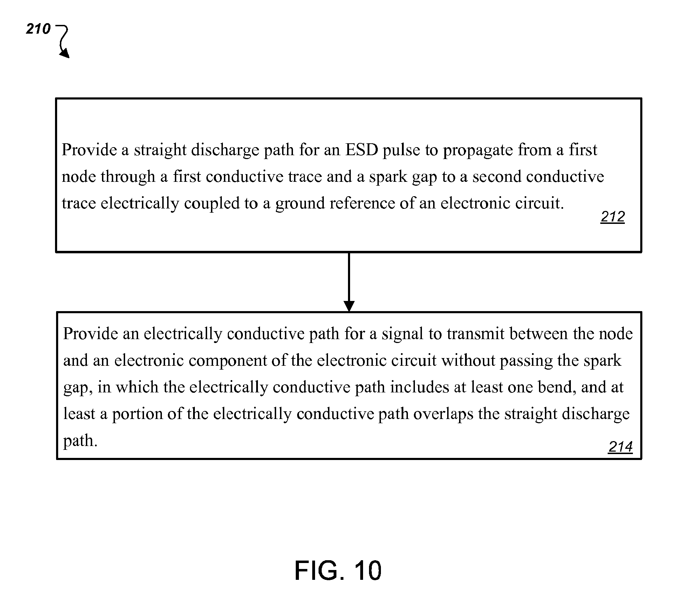

FIG. 10 is a diagram of an example process 210 for providing ESD protection to an electronic device. A straight discharge path is provided for an ESD pulse to propagate from a first node through a first conductive trace and a spark gap to a second conductive trace electrically coupled to a ground reference of an electronic circuit (212). For example, the straight discharge path can be the discharge path 120 of FIG. 1. An electrically conductive path is provided for a signal to transmit between the node and an electronic component of the electronic circuit without passing the spark gap. The electrically conductive signal path includes at least one bend, and at least a portion of the electrically conductive signal path overlaps the straight discharge path. For example, the electrically conductive signal path can be the signal path 122.

A number of examples of the invention have been described. Nevertheless, it will be understood that various modifications may be made without departing from the spirit and scope of the invention. For example, the angle between the first signal line 114 and the second signal line 116 can be different from 90 degrees, such as in a range between 75 to 105 degrees. For example, the bend 130 of the second signal line 116 can have an angle different from 90 degrees, such as in a range between 75 to 105 degrees. The second signal line 116 can have multiple bends. Multiple spark gap devices can be placed in parallel. The conductive traces of the spark gap devices can use a different material than the signal lines, such as a metal alloy having a higher melting point. The conductive trace 104 can be regarded as an extension of the signal line 114, so in the example of FIG. 1, the second signal line 116 can be regarded as connecting to the first signal line 114 in a vicinity of an end of the first signal line 114. The ESD pulse can have positive or negative voltage levels with respective to the ground reference voltage. There can be multiple ground reference voltages in an electronic circuit.

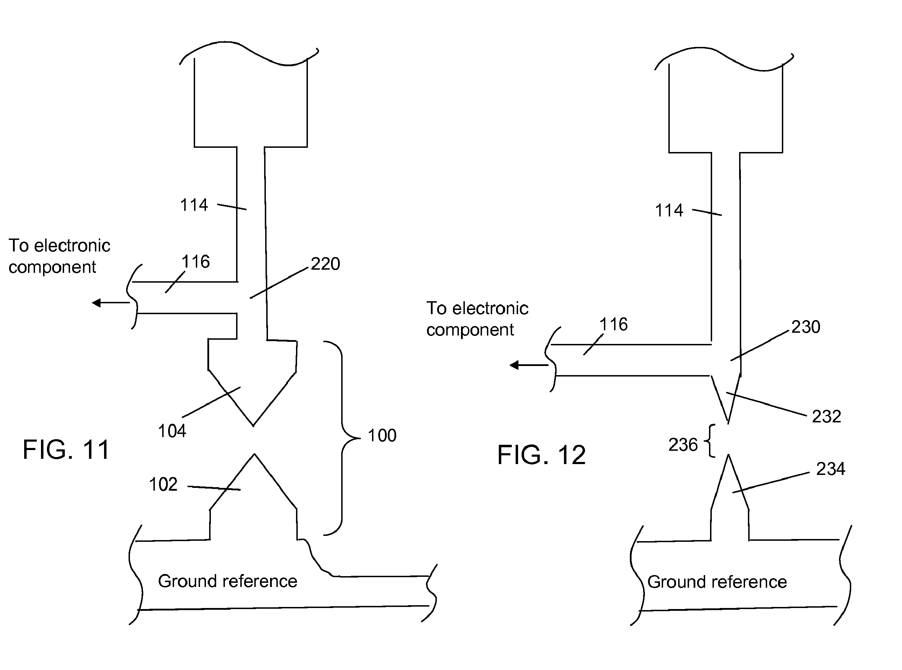

Referring to FIG. 11, in some implementations, the second signal line 116 can be connected to the first signal line 114 at an intersection 220 in a vicinity of the conductive trace 104 of the spark gap device 100. For example, a propagation distance from the intersection 220 to the conductive trace 102 (which is connected to the ground reference) is less than (e.g., less than half) a propagation distance from the intersection point 220 to an electronic component electrically coupled to the second signal line 116. This way, the ESD pulse is discharged to the ground reference before reaching the electronic component.

Referring to FIG. 12, in some implementations, the first and second signal lines 114 and 116 may appear to be a single signal line having a protrusion 232 at a bend 230 of the signal line. Spaced apart from the protrusion 232 is a conductive trace 234 that is electrically coupled to the ground reference, in which the protrusion 232 and the conductive trace 234 defines a spark gap 236.

Accordingly, other implementations and applications are within the scope of the following claims.

Although the invention is defined in the enclosed claims, it is to be understood that the present invention can alternatively be defined in accordance with the following embodiments:

1. An apparatus comprising: a first conductive line having a first end and a second end, the second end being electrically coupled to a ground reference of an electronic circuit; a second conductive line having a first end and a second end, the first end of the second conductive line being spaced apart from the first end of the first conductive line to define a spark gap between the first ends of the first and second conductive lines, the second end of the second conductive line being electrically coupled to a node to receive a signal; and a third conductive line connected to the second conductive line in a vicinity of the first end of the second conductive line, the third conductive line being electrically coupled to an electronic component of the electronic circuit, in which the third conductive line has a segment connected to the second conductive line and the segment is at an angle with respect to the second conductive line.

2. The apparatus of embodiment 1 in which the first and second conductive lines provide a straight discharge path through a segment of the second conductive line and the spark gap to the first end of the first conductive line.

3. The apparatus of embodiment 1 in which the first and second conductive lines provide a discharge path through a segment of the second conductive line and the spark gap to the first end of the first conductive line, the discharge path bending less than 30 degrees.

4. The apparatus of embodiment 1 in which the segment of the third conductive line is at an angle in a range of 75 to 105 degrees relative to the second conductive line.

5. The apparatus of embodiment 1 in which the segment of the third conductive line is perpendicular to the second conductive line.

6. The apparatus of embodiment 1 in which the third conductive line has a bend to reduce a likelihood that an electrostatic discharge will pass through the third conductive line to the electronic component.

7. The apparatus of embodiment 6 in which the third conductive line bends an angle in a range between 75 to 105 degrees.

8. The apparatus of embodiment 6 in which the third conductive line bends a 90 degree angle.

9. The apparatus of embodiment 1 in which the third conductive line has a segment that extends from the second conductive line to the bend, the segment extending along a direction at an angle relative to a discharge path from the second conductive line through the spark gap to the first conductive line.

10. The apparatus of embodiment 9 in which the segment of the third conductive line extends along a direction that is at an angle in a range between 75 to 105 degrees relative to the discharge path.

11. The apparatus of embodiment 1 in which the first and second conductive lines are disposed on a surface of a circuit board or an inner layer of a multi-layer circuit board.

12. The apparatus of embodiment 1 in which the first ends of the first and second conductive lines each comprises a tapered portion.

13. The apparatus of embodiment 1 in which the first ends of the first and second conductive lines are tapered along a first direction, and the second conductive line extends along the first direction.

14. The apparatus of embodiment 1 in which the first conductive line comprises a first solder pad located in a vicinity of the first end of the first conductive line, the second conductive line comprises a second solder pad located in a vicinity of the first end of the second conductive line, and the first and second solder pads are spaced apart at a distance to connect to connectors of an electrostatic discharge (ESD) protection device.

15. The apparatus of embodiment 14 in which the ESD protection device comprises a multilayer varistor or a transient voltage suppressor.

16. The apparatus of embodiment 14, further comprising the ESD protection device, the ESD protection device being stacked above the spark gap.

17. The apparatus of embodiment 14 in which the node is configured to receive the signal from a source external to the electronic circuit.

18. An apparatus comprising a first signal line extending along a first direction; a spark gap device having a first conductive trace and a second conductive trace, the first conductive trace being connected to the first signal line, the first and second conductive traces being spaced apart to define a spark gap, the first and second conductive traces being aligned along the first direction to direct an electrostatic discharge along the first direction from the first signal line through the spark gap to a ground reference electrically coupled to the second conductive trace; and a second signal line connected to the first conductive trace or to the first signal line in a vicinity of the first conductive trace, the second signal line extending along a second direction at an angle relative to the first direction.

19. The apparatus of embodiment 18 in which the first direction is at an angle in a range between 75 to 105 degrees relative to the second direction.

20. The apparatus of embodiment 18 in which the first and second conductive traces are disposed on a surface of a substrate, and the apparatus further comprises an electrostatic discharge protection device stacked above the spark gap relative to the surface, the electrostatic discharge protection device having connectors that are coupled to portions of the first and second conductive traces, respectively.

21. The apparatus of embodiment 20 in which the electrostatic discharge protection device comprises a multilayer varistor or a transient voltage suppressor.

22. The apparatus of embodiment 20 in which the second signal line is connected to a wider portion of the first conductive trace.

23. The apparatus of embodiment 20 in which the second signal line is connected to the first signal line at a first intersection point in a vicinity of the first conductive trace.

24. The apparatus of embodiment 20 in which the first and second conductive traces each comprises a tapered conductive trace having a wider portion and a narrower portion, and the narrower portion of the first conductive trace is spaced apart from the narrower portion of the second conductive trace to define the spark gap.

25. An apparatus comprising: a first conductive trace electrically coupled to a ground reference of an electronic circuit; a second conductive trace spaced apart from the first conductive trace to define a spark gap; a first conductive line having a first end and a second end, the first end connected to the second conductive trace, the second end electrically coupled to a node to receive a signal; and a second conductive line having a first end and a second end, the first end of the second conductive line being connected to the second conductive trace, the second end of the second conductive line being connected to an electronic component of the electronic circuit; wherein the first conductive line has a first segment that is connected to the second conductive trace, the second conductive line has a second segment that is connected to the second conductive trace, and the first segment is at an angle relative to the second segment.

26. The apparatus of embodiment 25 in which the first conductive trace has a wider portion and a narrower portion, and the wider portion is electrically coupled to the ground reference.

27. The apparatus of embodiment 26 in which the second conductive trace has a wider portion and a narrower portion, and the narrower portion of the second conductive trace is spaced apart from the narrower portion of the first conductive trace to define the spark gap.

28. The apparatus of embodiment 25 in which the first segment is at an angle in a range between 75 to 105 degrees relative to the second segment.

29. The apparatus of embodiment 25 in which the first segment of the first conductive line is parallel to, or at an angle within a range between -15 to 15 degrees relative to, a discharge path from the narrower portion of the second conductive trace to the narrower portion of the first conductive trace.

30. The apparatus of embodiment 25 in which the second segment of the second conductive line is perpendicular to, or at an angle within a range between 75 to 105 degrees relative to, a discharge path from the narrower portion of the second conductive trace to the narrower portion of the first conductive trace.

31. The apparatus of embodiment 25 in which the first and second conductive lines, and the first and second conductive traces are disposed on a surface of a circuit board or an inner layer of a multi-layer circuit board.

32. The apparatus of embodiment 25 in which the first conductive line comprises a first solder pad located in a vicinity of the first end of the first conductive line, the second conductive line comprises a second solder pad located in a vicinity of the first end of the second conductive line, and the first and second solder pads spaced apart at a distance to connect to connectors of an electrostatic discharge (ESD) protection device.

33. The apparatus of embodiment 32 in which the ESD protection device comprises a multilayer varistor or a transient voltage suppressor.

34. The apparatus of embodiment 32, further comprising the ESD protection device, the ESD protection device being stacked above the spark gap.

35. The apparatus of embodiment 25 in which the second conductive line has a third segment that is connected to the second segment and at an angle relative to the second segment.

36. An apparatus comprising: a conductive line having a first segment and a second segment that is at an angle relative to the first segment, the first segment to receive a signal from a pad, the second segment to connect to an electronic component of an electronic circuit; a first conductive trace coupled to the conductive line at an intersection of the first and second segments; and a second conductive trace spaced apart from the first conductive trace to define a spark gap, the second conductive trace electrically coupled to a ground reference of the electronic circuit.

37. The apparatus of embodiment 36 in which the first segment of the conductive line is parallel to, or at an angle within a range of -15 to 15 degrees relative to, an electrostatic discharge path through the spark gap, and the second segment of the conductive line is perpendicular to, or at an angle within a range of 75 to 105 degrees relative to, the electrostatic discharge path through the spark gap.

38. The apparatus of embodiment 36 in which the second segment of the conductive line comprises a first sub-segment and a second sub-segment that is at an angle relative to the second sub-segment, and the first sub-segment is connected to the first conductive trace.

39. The apparatus of embodiment 38 in which the second sub-segment is at an angle in a range of 75 to 105 degrees relative to the first sub-segment.

40. The apparatus of embodiment 36 in which the first conductive trace comprises a first solder pad, the second conductive trace comprises a second solder pad, and the first and second solder pads are spaced apart at a distance to connect to connectors of an electrostatic discharge (ESD) protection device.

41. The apparatus of embodiment 40, further comprising the ESD protection device, the ESD protection device being stacked above the spark gap.

42. An apparatus comprising: a first conductive trace coupled to a signal line; a second conductive trace spaced apart from the first conductive trace to define a spark gap, the second conductive trace electrically coupled to a ground reference of an electronic circuit; and an ESD protection device having a first connector and a second connector, the first connector connected to the first conductive trace, the second connector connected to the second conductive trace.

43. The apparatus of embodiment 42 in which the ESD protection device comprises a multilayer varistor or a transient voltage suppressor.

44. A wireless device comprising: a conductive line to provide an electrically conductive path from a connector pin or pad to an electronic component of an electronic circuit, the connector pin or pad to receive a signal from a source that is external to the wireless device, the conductive line having a first bend and a second bend; a first conductive trace coupled to the conductive line at the first bend; and a second conductive trace spaced apart from the first conductive trace to define a spark gap, the second conductive trace electrically coupled to a ground reference of the electronic circuit.

45. The apparatus of embodiment 44 in which each of the first and second bends comprises a bend forming an angle in a range between 75 to 105 degrees.

46. A method comprising: discharging an electrostatic discharge (ESD) pulse through a first conductive line, a first conductive trace connected to the first conductive line, a spark gap, and a second conductive trace to a ground reference of an electronic circuit, in which the first conductive trace and the second conductive trace are spaced apart to define the spark gap, and the second conductive trace is coupled to the ground reference; and transmitting a signal on the first conductive line and a second conductive line to or from an electronic component that is electrically coupled to the second conductive line, the second conductive line having a segment connected to the first conductive line or a portion of the first conductive trace, in which the segment is at an angle relative to the first conductive line.

47. The method of embodiment 46, comprising providing a bend in the third conductive line to reduce a likelihood that the ESD pulse will pass through the third conductive line to the electronic component.

48. The method of embodiment 47 in which providing a bend in the third conductive line comprises providing a bend having an angle in a range between 75 to 105 degrees.

49. The method of embodiment 46 in which passing a signal through the first conductive line comprises passing a signal received from a source external to the electronic circuit.

50. The method of embodiment 46, further comprising discharging an ESD pulse through an ESD protection device that has a first connector and a second connector, the first connector coupled to the first conductive line, the second connector coupled to the second conductive line.

51. The method of embodiment 46 in which discharging an ESD pulse through a first conductive line, a first conductive trace, and a second conductive trace to a ground reference comprises discharging an ESD pulse through a first conductive line, a first conductive trace, and a second conductive trace to a ground reference that are disposed on an outer or inner surface of a circuit board.

52. A method comprising: providing a straight discharge path for an electrostatic discharge (ESD) pulse to propagate from a first node through a first conductive trace and a spark gap to a second conductive trace electrically coupled to a ground reference of an electronic circuit; and providing an electrically conductive path for a signal to transmit between the node and an electronic component of the electronic circuit without passing the spark gap, in which the electrically conductive signal path includes at least one bend, and at least a portion of the electrically conductive signal path overlaps the straight discharge path.

53. The method of embodiment 52, comprising overlapping the straight discharge path and the electrically conductive path at the first signal line.

54. The method of embodiment 53, comprising positioning the bend at a location where the electrically conductive path and the straight discharge path diverge.

55. The method of embodiment 53, comprising providing another bend at a location of the electrically conductive path after the electrically conductive path diverge from the straight discharge path.

56. The method of embodiment 52, comprising stacking an ESD protection device above the spark gap to provide a second discharge path for the ESD pulse.

57. The method of embodiment 52 in which providing an electrically conductive path comprises providing an electrically conductive path through conductive elements on an outer or inner surface of a circuit board.

## Claims

1. An apparatus comprising:
a first conductive line having a first end and a second end, the second end being electrically coupled to a ground reference of an electronic circuit;
a second conductive line having a first end and a second end, the first end of the second conductive line being spaced apart from the first end of the first conductive line to define a spark gap between the first ends of the first and second conductive lines, the second end of the second conductive line being electrically coupled to a node to receive a signal; and
a third conductive line connected to the second conductive line in a vicinity of the first end of the second conductive line, the third conductive line being electrically coupled to an electronic component of the electronic circuit, in which the third conductive line has a segment connected to the second conductive line and the segment is at an angle with respect to the second conductive line.

2. The apparatus of claim 1 in which the first and second conductive lines provide a straight discharge path through a segment of the second conductive line and the spark gap to the first end of the first conductive line.

3. The apparatus of claim 1 in which the first and second conductive lines provide a discharge path through a segment of the second conductive line and the spark gap to the first end of the first conductive line, the discharge path bending less than 30 degrees.

4. The apparatus of claims 2 or 3 in which the segment of the third conductive line is at an angle in a range of 75 to 105 degrees relative to the second conductive line.

5. The apparatus of claims 1 to 4 in which the segment of the third conductive line is perpendicular to the second conductive line.

6. The apparatus of claims 1 to 4 in which the third conductive line has a bend to reduce a likelihood that an electrostatic discharge will pass through the third conductive line to the electronic component.

7. The apparatus of claim 6 in which the third conductive line bends an angle in a range between 75 to 105 degrees.

8. The apparatus of claim 6 in which the third conductive line bends a 90 degree angle.

9. The apparatus of claim 1 in which the third conductive line has a segment that extends from the second conductive line to the bend, the segment extending along a direction at an angle relative to a discharge path from the second conductive line through the spark gap to the first conductive line.

10. The apparatus of claim 9 in which the segment of the third conductive line extends along a direction that is at an angle in a range between 75 to 105 degrees relative to the discharge path.

11. The apparatus of claim 1 in which the first and second conductive lines are disposed on a surface of a circuit board or an inner layer of a multi-layer circuit board.

12. A wireless device comprising:
a conductive line to provide an electrically conductive path from a connector pin or pad to an electronic component of an electronic circuit, the connector pin or pad to receive a signal from a source that is external to the wireless device, the conductive line having a first bend and a second bend;
a first conductive trace coupled to the conductive line at the first bend; and
a second conductive trace spaced apart from the first conductive trace to define a spark gap, the second conductive trace electrically coupled to a ground reference of the electronic circuit.

13. The apparatus of claim 12 in which each of the first and second bends comprises a bend forming an angle in a range between 75 to 105 degrees.

14. A method comprising:
discharging an electrostatic discharge (ESD) pulse through a first conductive line, a first conductive trace connected to the first conductive line, a spark gap, and a second conductive trace to a ground reference of an electronic circuit, in which the first conductive trace and the second conductive trace are spaced apart to define the spark gap, and the second conductive trace is coupled to the ground reference; and
transmitting a signal on the first conductive line and a second conductive line to or from an electronic component that is electrically coupled to the second conductive line, the second conductive line having a segment connected to the first conductive line or a portion of the first conductive trace, in which the segment is at an angle relative to the first conductive line.

15. The method of claim 14, comprising providing a bend in the third conductive line to reduce a likelihood that the ESD pulse will pass through the third conductive line to the electronic component.
